(19) Europäisches Patentamt

European Patent Office

Office européen des brevets

(11) **EP 1 643 568 A1**

(12) **EUROPÄISCHE PATENTANMELDUNG**

(43) Veröffentlichungstag:
    **05.04.2006 Patentblatt 2006/14**

(51) Int Cl.:
    **_H01L 51/40_** _(2006.01)_        **_C23C 14/12_** _(2006.01)_

(21) Anmeldenummer: **04023606.9**

(22) Anmeldetag: **04.10.2004**

(84) Benannte Vertragsstaaten:
    **AT BE BG CH CY CZ DE DK EE ES FI FR GB GR HU IE IT LI LU MC NL PL PT RO SE SI SK TR**
    Benannte Erstreckungsstaaten:
    **AL HR LT LV MK**

(71) Anmelder: **Novaled GmbH**
    **01307 Dresden (DE)**

(72) Erfinder:
    • **Werner, Ansgar**
      **01277 Dresden (DE)**

    • **Birnstock, Jan**
      **01187 Dresden (DE)**
    • **Murano, Sven**
      **01127 Dresden (DE)**

(74) Vertreter: **Bittner, Thomas L.**
    **Forrester & Boehmert**
    **Pettenkoferstrasse 20-22**
    **80336 München (DE)**

Bemerkungen:
    Geänderte Patentansprüche gemäss Regel 86 (2) EPÜ.

(54) **Verfahren zum Herstellen einer Schicht aus einem dotierten Halbleitermaterial und Vorrichtung**

(57) Die Erfindung bezieht sich auf ein Verfahren zum Herstellen einer Schicht aus einem dotiertem Halbleitermaterial auf einem Substrat mittels Abscheiden, sowie eine Vorrichtung zum Ausführen des Verfahrens, wobei bei dem Verfahren das dotierte Halbleitermaterial mindestens ein Halbleiter-Matrixmaterial und mindestens ein Dotierungsmaterial enthält. Eine Mischung des mindestens einen Halbleiter-Matrixmaterials und des mindestens einen Dotierungsmaterials wird mit Hilfe einer Verdampfungsquelle in eine Dampfphase überführt und anschließend auf dem Substrat abgeschieden.

**Beschreibung**

Die Erfindung betrifft ein Verfahren zum Herstellen einer Schicht aus einem dotierten Halbleitermaterial auf einem Substrat mittels Abscheiden, insbesondere einer Schicht für eine organische Leuchtdiode, sowie eine Vorrichtung zum Ausführen des Verfahrens, wobei das dotierte Halbleitermaterial mindestens ein Halbleiter-Matrixmaterial und mindestens ein Dotierungsmaterial enthält.

Hintergrund der Erfindung

Derartige dotierte Schichten können beispielsweise bei organischen Leuchtdioden (OLED) vorgesehen sein. Hierbei sind verschiedene Arten dotierter Schichten zu unterscheiden. Ladungsträgertransportschichten werden mit starken Donor- bzw. starken Akzeptorverbindungen dotiert. Es wird mittels eines Ladungstransfers zwischen Matrixmaterial und Dotierungsmaterial eine erheblich höhere Leitfähigkeit dieser Schichten für Elektronen oder Löcher erzeugt. Dieses verbessert die elektrischen Eigenschaften organischer Leuchtdioden dahingehend, daß eine geringere Betriebsspannung für eine bestimmte Helligkeit benötigt wird. Darüber hinaus ergeben sich eine Vielzahl weiterer Vorteile, beispielsweise eine bessere Ladungsträgerinjektion aus den Elektroden, für deren Herstellung deshalb eine weitere Auswahl an Materialien in Frage kommt. Weiterhin können die Dicken der so dotierten Schichten in einem weiten Bereich variiert werden, ohne daß ohmsche Verluste in den Transportschichten die Leistung des Bauelements beeinträchtigen. So kann beispielsweise die Schichtdicke so gewählt werden, daß das im Bauelement entstehende Licht durch konstruktive Interferenz optimal aus dem Bauelement ausgekoppelt wird.

Für solche dotierte Schichten werden häufig molare Konzentrationen von 1:1 bis 1:100 gewählt. Dotierte organische Halbleiterschichten werden auch in anderen organischen Bauelementen wie zum Beispiel organischen Solarzellen oder organischen TFTs eingesetzt. Eine solche dotierte Schicht kann beispielsweise aus einer Mischung von 4,4,4-tris(3-methylphenylphenylamino)tri-phenylamin (m-MTDATA) und Tetrafluoro Tetracyano Chinodimethan (F4-TCNQ) im molaren Verhältnis 50:1 bestehen. Eine andere Ausprägung einer solchen dotierten Schicht kann aus Bathophenanthroline (BPhen) und Cäsium im molaren Verhältnis von beispielsweise 8:1 bestehen.

Eine weitere Art der Dotierung sieht das Einmischen von lichtemittierenden Dotanden in ein Matrixmaterial vor (Tang et al., J. Appl. Phys. 65, 3610 (1989)). Diese Mischung bildet dann die lichtemittierende Schicht in einer organischen Leuchtdiode. Solche dotierten Schichten weisen in der Regel eine höhere Lumineszenzquantenausbeute auf und erlauben es, das Spektrum des emittierten Lichtes zu beeinflußen. Für solche dotierten Schichten werden häufig Dotierkonzentrationen von 1:2 bis 1:1000 gewählt. Beispielsweise kann eine solche dotierte lichtemittierende Schicht aus 4,4', 4"-tris(N-carbazolyl)-triphenylamine (TCTA) und fac-tris(2-phenylpyridine) iridium $(Ir(ppy)_3)$ im Massenverhältnis 5:1 bestehen.

In organischen Solarzellen werden Mischschichten, sogenannte "bulk heterojunctions", eingesetzt, um eine höhere Quantenausbeute für die Umwandlung von Licht in Ladungsträger zu erreichen (Gebeyehu et al., Solar Energ. Mater. Solar Cells 79, 81 (2003)).

Aufgrund der Absorption von Licht in organischen Materialien entsteht zunächst ein Elektron-Lochpaar mit einer sehr hohen Bindungsenergie. In reinen Materialien ist es deshalb schwierig, dieses so genannte Exziton in ungebundene Ladungsträger aufzuspalten. Deshalb wird eine Mischung aus donorartigen und akzeptorartigen Materialien eingesetzt. Das Exziton wird hierbei durch Ladungsübertrag vom Donor auf den Akzeptor aufgetrennt. Für solche dotierten Schichten werden häufig Dotierkonzentrationen von 1:1 bis 1:10 gewählt. Beispielsweise kann eine solche dotierte Schicht aus Pthalozyanin Zink und Fulleren C60 im molaren Verhältnis 2:1 bestehen.

Schließlich wird in der Literatur berichtet, daß gemischte dotierte Schichten zur Erhöhung der Stabilität von organischen Bauelementen verwendet werden können (Shi et al., Appl. Phys. Lett. 70, 1665 (1997). Für einige Anwendungen von dotierten Halbleiterschichten sind auch Mischungen mit mehr als zwei Komponenten vorteilhaft (vgl. zum Beispiel US 6,312,836 B1, US 6,287,712).

Beim Herstellen organischer, dotierter Halbleiterschichten wird die organische Substanz in die gasförmige Phase überführt und dann abgeschieden. Prinzipiell können organische Substanzen entweder aus der flüssigen oder aus der festen Phase in die gasförmige Phase übergehen. Im ersten Fall spricht man vom Verdampfen, im zweiten Fall von Sublimation. Um die Lesbarkeit zu erleichtern, werden im folgenden beide Bezeichnungen synonym verwendet und sollen jeweils sowohl das Aufdampfen aus der festen als auch der flüssigen Phase umfassen.

Dotierte organische Schichten werden bisher mittels Mischverdampfung hergestellt. Hierbei werden Matrixmaterial und Dotierungsmaterial in eine jeweilige Verdampfungsquelle (Verdampfer) gefüllt und unter Hochvakuumbedingungen zur selben Zeit sublimiert. Der Dampf aus beiden Verdampfungsquellen wird auf einem Substrat abgeschieden. In Abhängigkeit von den gewählten Verdampfungsraten, der Abstrahlcharakteristik der Verdampfungsquellen und der Geometrie der Anordnung ergibt sich ein bestimmtes Mischungsverhältnis der entstehenden Schicht.

Dieses Verfahren weist eine Reihe von Nachteilen auf. Es ist nötig, die Aufdampfraten der Verdampfungsquellen während des gesamten Verdampfungsprozesses sehr genau zu kontrollieren, um eine homogene Dotierung zu erreichen. Weiterhin müssen die Abstrahlcharakteristik und die Anordnung der Verdampfungsquellen so beschaffen sein, daß auf der ganzen Fläche des Substrates das Verhältnis der Flüsse von Matrixmaterial und Dotand konstant ist. Dieses ist vor allem für Substrate mit einer großen Grundfläche nur sehr aufwändig zu gewährleisten. Weiterhin ergibt sich für jede dotierte Schicht die Notwendigkeit, einen zusätzlichen Verdampfer für den Dotanden bei der Projektierung einer Verdampfungsanlage vorzusehen. Nicht zuletzt erhöht sich der Wartungsaufwand für eine solche Anlage beträchtlich. Schließlich ergibt sich ein deutlich erhöhter Aufwand an Regeltechnik für den Betrieb der Verdampfer.

### Die Erfindung

Aufgabe der Erfindung ist es, ein Verfahren zum Herstellen einer Schicht aus einem dotierten Halbleitermaterial auf einem Substrat mittels Abscheiden, insbesondere einer Schicht für eine organische Leuchtdiode, sowie eine Vorrichtung zum Ausführen des Verfahrens anzugeben, bei denen die Nachteile des Standes der Technik überwunden sind.
Diese Aufgabe wird durch ein Verfahren mit den Merkmalen des unabhängigen Anspruchs 1 sowie eine Vorrichtung mit den Merkmalen des unabhängigen Anspruchs 16 gelöst.
Vorteilhafte Ausgestaltungen der Erfindung sind Gegenstand von abhängigen Unteransprüchen.
Erfindungsgemäß ist ein Verfahren zum Herstellen einer Schicht aus einem dotierten Halbleitermaterial auf einem Substrat mittels Abscheiden geschaffen, wobei das dotierte Halbleitermaterial mindestens ein Halbleiter-Matrixmaterial und mindestens ein Dotierungsmaterial enthält, und wobei eine Mischung des mindestens einen Halbleiter-Matrixmaterials und des mindestens einen Dotierungsmaterials mit Hilfe einer Verdampfungsquelle in eine Dampfphase überführt und anschließend auf dem Substrat abgeschieden wird. Es können Mischungen von zwei oder mehr Materialien zum Einsatz kommen.
Mit dem vorgeschlagenen Verfahren wird die Herstellung von dotierten Schichten vereinfacht. Die Eigenschaften der molekularen Flüsse von Matrixmaterial und Dotand können gleichartig gestaltet werden, weil beide aus derselben Verdampfungsquelle sublimiert/verdampft werden. Das Verhältnis der Verdampfungsraten ist weitgehend zeitunabhängig, da nur noch eine Temperatur zu kontrollieren ist. Weiterhin können Verdampferanlagen zum Ausführen des Verfahrens vereinfacht ausgestaltet werden. Es entfällt der Aufwand für mindestens eine Verdampfungsquelle bei Planung und Betrieb der Verdampferanlage zur Herstellung von Bauelementen mit dotierten Halbleiterschichten, insbesondere bei der Herstellung von Bauelementen mit organischen Schichten wie organische Leuchtdioden.
Das Verfahren ist in Verbindung mit unterschiedlichen Verfahrensgestaltungen nutzbar. So können neben einer Verdampfung mittels Zuführen thermischer Energie auch die Nutzung von Laserlichtimpulsen und die Molekularstrahlepitaxie vorgesehen sein.

### Beschreibung von bevorzugten Ausführungsbeispielen

Die Erfindung wird im folgenden anhand von Ausführungsbeispielen näher erläutert.
Bei der Nutzung der thermischen Verdampfung im Vakuum zum Herstellen einer Schicht aus einem dotierten Halbleitermaterial wird das zu verdampfende Material in einen Tiegel aus Keramik, Glas, Metall oder ähnlichen Stoffen gefüllt. Der Tiegel wird dann erwärmt, wodurch das zu verdampfende Material in die Gasphase überführt wird. In Abhängigkeit von der Bindungsenergie der flüssigen oder der festen Phase stellt sich eine geeignete Sublimationsrate bei verschiedenen Temperaturen ein. Beispielsweise kann der Dotand F4-TCNQ bereits bei 120°C verdampft werden, während Fulleren C60 erst bei 400°C verdampft werden kann.
Es wurde überraschend gefunden, daß es trotzdem möglich ist, eine Materialmischung mit einem zeitunabhängigen Verhältnis der Flüsse der Materialien zu verdampfen. Im folgenden werden unterschiedliche Ausführungsbeispiele beschrieben.

### Ausführungsbeispiel 1

In einem Ausführungsbeispiel unterscheiden sich die Sublimations- / Verdampfungstemperaturen der beteiligten Materialien um weniger als etwa 50°C, bevorzugt um weniger als etwa 20°C. Unter Sublimationstemperatur wird hier diejenige Temperatur verstanden, die benötigt wird, um die gewünschte Dotierkonzentration in einer Verdampferanlage einzustellen, in der das Matrixmaterial und der Dotand aus zwei direkt benachbarten, getrennten Quellen mit den gleichen Oberflächen verdampft werden. Da die Verdampfung ein thermisch aktivierter Prozeß ist, steigt die Verdampfungsrate sehr stark mit der Temperatur an. Deshalb wäre zu erwarten, daß eine Mischung aus zwei verschiedenen Materialien in einem Tiegel nicht zu einer gleichzeitigen Sublimation/Verdampfung der Mischung mit einem zeitunabhängigen Verhältnis der Flüsse der Materialien führt. Vielmehr wäre zu erwarten, daß in diesem Fall zunächst die leichter flüchtige Komponente schnell in die Gasphase übergeht, während nach deren Verbrauch die weniger flüchtige Komponente sich allein im Tiegel befindet.
Eine im Vergleich zu einer anderen Komponente weniger flüchtige Komponente liegt vor, wenn die Komponente eine Verdampfungs- / Sublimationstemperatur aufweist, die größer als eine Verdampfungs- / Sublimationstemperatur der anderen Komponente ist.

Das gefundene Verhalten beim Herstellen des dotierten Materials kann dadurch erklärt werden, daß sich die Oberfläche einer festen, leichter flüchtigen Komponente, nämlich diejenige mit der geringeren Sublimations- / Verdampfungstemperatur, durch die zunächst schnellere Sublimation/Verdampfung verringert, so daß sich die Sublimations- / Verdampfungsrate verringert, bis sie in einem stabilen Verhältnis zur Sublimations- / Verdampfungsrate der schwerer flüchtigen Komponente steht.

In einigen Fällen kann es unmöglich sein, Matrixmaterial und Dotand so zu wählen, daß deren Sublimationstemperaturen um weniger als etwa 50°C, vorteilhaft um weniger als etwa 20°C, differieren. Dies kann dann der Fall sein, wenn eine bestimmte zusätzlich benötigte Eigenschaft des Matrixmaterials oder des Dotanden wie Farbigkeit, Redoxpotentiale oder Lumineszenzquanteneffizienz nur innerhalb einer eingeschränkten Klasse von Materialien realisiert werden kann. In diesen Fällen sind weitere Maßnahmen vorgesehen, um ein zeitlich konstantes Verhältnis der Verdampfungsraten von Matrixmaterial und Dotand zu gewährleisten. Hierbei kommt es zudem darauf an, ob das Matrixmaterial bei der Sublimationstemperatur in fester oder flüssiger Form vorliegt, und ob zwischen Matrixmaterial und Dotand bei der Mischung eine chemische Reaktion stattfindet.

Ohne das hierdurch der Bereich der Erfindung beschränkt werden würde, kann die Sublimation als thermisch aktivierter Prozeß verstanden werden, bei dem der molekulare Fluß $\Phi_M$ einer Verbindung M als

$$\Phi_M = \rho(r,\alpha) \cdot \sigma_M A \cdot \nu \exp(-H_{sub}/kT)$$

dargestellt werden kann, wobei $H_{sub}$ die Sublimationsenthalpie des Materials, k die Boltzmannkonstante, $T$ die Temperatur, $\nu$ eine Ratenkonstante der Einheit 1/s, $\sigma_M$ die Flächendichte des Materials an der Oberfläche des gesamten zu verdampfenden Materials und $A$ der Flächeninhalt der Oberfläche ist. Der Faktor $\rho(r,\alpha)$ beschreibt die Abhängigkeit des Flusses vom Abstand und Winkel zur Tiegelnormalen, mithin die Verdampfercharakteristik.

Für ein reines Material ist die Flächendichte $\sigma_M$ gleich der Flächendichte des reinen Materials $\sigma_M{}^*$, und die Oberfläche $A$ ist gleich der Oberfläche des Materials. Für eine homogene Mischung von mehreren Materialien ist die Flächendichte des Materials M1 entsprechend dem Anteil $x_1$ des Materials M1 an der Mischung herabgesetzt: $\sigma_M = x_1 \sigma_M{}^*$. Die Oberfläche $A$ ist dann die Oberfläche der Mischung.

Die Sublimationsenthalpie $H_{sub}$ eines reinen Materials ist gleich der Sublimationsenthalpie $H_{sub}{}^*$ des reinen Materials. Die Sublimationsenthalpie eines Materials M in einer Mischung kann von dem Wert $H_{sub}{}^*$ stark abweichen. Dieses hängt von der Art der Mischung und der Art der Wechselwirkung von M mit anderen Bestandteilen der Mischung ab. In dem Falle, daß die Mischung aus großen Kristalliten der verschiedenen zu verdampfenden Materialien besteht, besteht die Umgebung eines Moleküls M im wesentlichen aus anderen Molekülen M der selben Art und die Sublimationsenthalpie entspricht näherungsweise dem Wert des reinen Materials $H_{sub}{}^*$. Im Falle einer sehr feinen Mischung mit sehr kleinen Kristalliten oder einer vollständigen Durchmischung der Moleküle kann die Sublimationsenthalpie der Verbindung M vom Wert des reinen Materials $H_{sub}{}^*$ abweichen, da die Moleküle M jetzt auch mit den andersartigen Molekülen der Mischung wechselwirken. Im Falle einer sehr starken Wechselwirkung kann die Sublimationsenthalpie sehr hohe Werte annehmen. Dies ist beispielsweise dann der Fall, wenn Moleküle M einen Ladungsübertrag zu anderen Molekülen der Mischung durchführen und sich ein organisches Salz bildet.

Bei dem erfindungsgemäßen Verfahren werden die Verhältnisse der molekularen Flüsse an bestimmten Ortspositionen bei der Sublimation aus nur einem Tiegel betrachtet. Dadurch ist der Faktor $\rho(r,\alpha)$ für alle Materialien im Tiegel gleich und fällt bei der Verhältnisbildung heraus. Demzufolge muß dieser Faktor nicht weiter betrachtet werden.

Um ein bestimmtes Verhältnis der Flüsse $\Phi_{M1}/\Phi_{M2}$ zweier Materialien M1 und M2 in einem Tiegel zu erhalten, können die Parameter $\sigma_{M1}$ bzw. $\sigma_{M2}$, sowie die Parameter $H_{sub1}$ und $H_{sub2}$ beeinflußt werden. Die Temperatur hingegen ist die Temperatur des Tiegels und damit für alle Materialien im Tiegel gleich.

Die Flächendichte $\sigma_M$ eines Materials ist definiert als die Anzahl der sich an der Oberfläche der Tiegelfüllung befindlichen Moleküle M geteilt durch die Oberfläche der gesamten Tiegelfüllung. Es sind verschiedene Möglichkeiten denkbar, die Flächendichte zu variieren. Eine Möglichkeit besteht darin, den Anteil einer zu leicht flüchtigen Komponente in der zu verdampfenden Mischung zu verringern und so über die verringerte Flächendichte den molekularen Fluß bei einer bestimmten Temperatur herabzusetzen.

In einer Ausführung des in den vorhergehenden Abschnitten beschriebenen Ausführungsbeispiels wurden 22 mg Tetrazen und 4,3 mg Tetrafluoro-Tetracyano-Chinodimethan ($F_4$-TCNQ) eingewogen und gemeinsam in einen Verdampfer mit Keramiktiegel gefüllt. Die Sublimation der Mischung bei 140°C ergibt eine 450 nm dicke Schicht mit einer Leitfähigkeit größer 5e-8 S/cm. Am Ende des Verdampfungsvorgangs entstehen noch 50 nm Schichtdicke mit geringerer Leitfähigkeit. Bei der Sublimation von Tetrazen bzw. $F_4$-TCNQ in reiner Form betragen die Sublimationstemperaturen zum Vergleich 140°C bzw. 130°C.

Ausführungsbeispiel 2

Eine weitere, über die obige Beschreibung hinausgehende Möglichkeit, den molekularen Fluß einer zu leicht flüchtigen Komponente einer Mischung herabzusetzen, ist, diese Komponente fest in die Mischung einzubetten. Dies geschieht beispielsweise mittels Verpressen der Mischung. Die Verpressung kann in gewöhnlichen Preßvorrichtungen erfolgen, wie sie beispielsweise zur Herstellung von KBr-Tabletten in der Infrarotspektroskopie eingesetzt werden. Dabei ist der molekulare Anteil der leichter flüchtigen Komponente vorteilhaft 50% oder kleiner, vorteilhafter 10% und kleiner. Mit Hilfe des Verpressens werden alle Poren in der Mischung komprimiert. Die leichter flüchtige Komponente kann demnach nur insoweit sublimieren, wie sich deren Moleküle gerade an der Oberfläche befinden. In diesem Fall wird angenommen, daß die Mischung vor oder während der Sublimation nicht in die flüssige Phase übergeht. Da die leichter flüchtige Komponente fest in die schwerer flüchtige Komponente eingebaut ist, ergibt sich, daß die leichter flüchtige Komponente nur dann sublimieren kann, wenn deren Moleküle gleichzeitig durch die Sublimation der schwerer flüchtigen Komponente an die Oberfläche gelangen, d.h. freigelegt werden. Auf diese Weise bestimmt sich der Fluß der leichter flüchtigen Komponente aus dem Mischungsverhältnis in der Mischung und dem Fluß der schwerer flüchtigen Komponente. Insbesondere entspricht das Verhältnis der molekularen Flüsse dem Mischungsverhältnis der Mischung.

Bei einer Ausführung für das vorgenannte Ausführungsbeispiel wurden 4,4 g Naphthalene Tetracarbonsäure Dianhydrid (NTCDA) und 0,12 g Leuko Kristallviolett (LCV) gemischt und in einer Kugelmühle unter Lichtabschluß bei Raumtemperatur gemahlen. Man erhält ein Pulver mit leicht violetter Färbung. LCV wandelt sich durch irreversible Oxidation in das Kristallviolett Kation (CV), wenn es in eine elektronenakzeptierende Matrix wie NTCDA eingebracht wird. Diese Reaktion findet in der Abwesenheit von Licht und bei Raumtemperatur sehr langsam statt. Das mittels Mahlen hergestellte Pulver ist also eine Mischung von LCV mit NTCDA, bei der nur ein kleiner Teil des LCV zu CV reagiert hat.

Ein Teil des Pulvers wurde in einer Presse unter einem Druck von 5 Tonnen 3 Minuten zu einer Tablette mit 1 cm Durchmesser und einer Höhe von 1 mm verpreßt. Man erhält einen homogen dunkelblau erscheinenden festen Körper. Dabei ist die blaue Färbung nicht notwendigerweise auf eine weitergehende Oxidation von LCV zu CV zurückzuführen, sondern kann ebenso auf eine hohe Transparenz der entstandenen Tablette und der damit verbundenen Integration der Absorption der bereits entstandenen CV Kationen zurückzuführen sein. Bei dem erfindungsgemäßen Verfahren ist es jedoch unerheblich, in welchem Maße die Tablette bereits oxidiertes LCV enthält.

Ein Viertel des erhaltenen Preßlings wurde in einen handelsüblichen Verdampfer mit Keramiktiegel gegeben und unter Hochvakuumbedingungen bei etwa 190°C auf einem Substrat abgeschieden. LCV hat sich in früheren Experimenten als eine leicht flüchtige Substanz erwiesen, die bereits bei 150°C sublimiert. Die verwendete Sublimationstemperatur von 190°C entspricht jedoch dem Erfahrungswert für NTCDA. Die entstehende Schicht wird mit dem Licht einer Halogenlampe bestrahlt. Dies führt zu einer Aktivierung des Dotierprozesses. Die Leitfähigkeit der entstehenden Schichten wird kontinuierlich gemessen.

In einem ersten Schritt wurde eine Gesamtschichtdicke von 1 $\mu$m aufgedampft, wobei die entstehende Leitfähigkeit der ersten 300nm größer als 1e-5 S/cm und für die verbleibende Schichtdicke größer als 1e-6 S/cm war. Schichten, die aus undotiertem NTCDA bestehen, haben eine Leitfähigkeit geringer als 1e-8 S/cm. Daraus läßt sich schließen, daß die bei der Verdampfung des Preßlings entstehenden Schichten eine homogene Dotierung aufweisen.

In einem zweiten Schritt wurde eine weitere Schichtdicke von 600nm abgeschieden, wobei die Leitfähigkeit auch dabei größer als 1e-6 S/cm ist. Schließlich werden weitere 200nm mit einer geringeren Leitfähigkeit abgeschieden, bis schließlich der Preßling vollständig verdampft ist. Für eine mittels Mischverdampfung hergestellte Probe von LCV: C60 mit Dotierverhältnis 1:50 beträgt die Leitfähigkeit einer frisch präparierten Schicht etwa 5e-5 S/cm.

Ausführungsbeispiel 3

Bei einem weiteren Ausführungsbeispiel findet eine chemische Reaktion zwischen dem Matrixmaterial und dem Dotierungsmaterial statt, wodurch es möglich ist, daß die Flüchtigkeit des Dotanden aufgrund der chemischen Bindung sehr stark herabgesetzt wird. Bildet sich beispielsweise eine ionische Bindung aus, müßten zur Verdampfung zunächst durch Ladungsrückübertragung neutrale Moleküle gebildet werden, die dann in die Gasphase übergehen. In diesem Fall wird in der Regel eine weit höhere Energie benötigt, als sie bei praktikablen Sublimationstemperaturen zur Verfügung steht.

In diesem Fall ist es zweckmäßig, Matrixmaterial und Dotierungsmaterial mittels nur leichten Rühren zu vermischen. Hierdurch wird die Mikrostruktur von Matrixmaterial und Dotand erhalten, so daß die chemische Reaktion nur zu einem geringen Teil an den Korngrenzen abläuft. Es ist möglich, die Korngrößen von Matrix und Dotand so zu wählen, daß einerseits chemische Reaktionen unterdrückt werden, aber andererseits eine genügend homogene Mischung zu erreichen ist.

Die Abhängigkeit der Sublimationstemperatur der Mischung von der Stärke der chemischen Bindung kann auch gezielt dafür eingesetzt werden, die Sublimationstemperatur der leichter flüchtigen Komponente zu erhöhen. Dies ist dann der Fall, wenn die thermische Energie bei der Sublimationstemperatur der schwerer flüchtigen Komponente gerade ausreicht, die chemische Bindung zwischen beiden Komponenten aufzutrennen. Bei Mischungen von donor- und akzeptorartigen Komponenten kann das dann der Fall sein, wenn beide Komponenten nur einen partiellen Ladungsübertrag durchführen, oder wenn die jeweiligen Ionisationspotentiale und Elektronenaffinitäten bezogen auf die Matrix nicht zu weit auseinanderliegen. Der Grad der Ladungsübertragung kann mittels Infrarotspektroskopie gemessen werden. Die Ionisationspotentiale und Elektronenaffinitäten können mit Hilfe der Redoxpotentiale der beteiligten Komponenten angenähert werden.

In jedem Falle ist es zweckmäßig, beide Komponenten vor der Verwendung gut zu vermischen, zum Beispiel mittels gemeinsamen Zermahlen in einer Kugelmühle oder einem Mörser. Darüber hinaus kann auch ein Material als schwerer flüchtiges Material gewählt werden, welches unterhalb der Sublimationstemperatur flüssig wird und so eine chemische Reaktion zwischen beiden Komponenten erleichtert.

Bei einer Ausführung des vorgenannten Ausführungsbeispiels wurden 44.9 mg m-MTDATA und 15.5 mg F4TCNQ eingewogen und in einem Mörser 5 Minuten intensiv vermischt. Dabei entsteht ein tiefgrünes Pulver. Dieses Pulver besteht gemäß der Einwaage aus einer stöchiometrischen Mischung der beiden Komponenten im Verhältnis 1: 1. Die Mischung wurde in einer Vakuumkammer bis 400°C erhitzt, ohne daß eine Sublimation sichtbar wurde.

Bei einer weiteren Ausführung wurden 0.88g m-MTDATA und 6.4 mg F4-TCNQ eingewogen und gemischt. Ausweislich der Einwaage hat die Mischung ein molekulares Mischungsverhältnis von m-MTDATA: F4-TCNQ von 50: 1. Die Mischung wurde in einer Vakuumkammer bei 193°C verdampft. Die dabei entstehende Schicht wies eine Leitfähigkeit von geringer als 1 e-9 S/cm auf und war mithin undotiert.

Für mittels Mischverdampfung hergestelltes p-dotiertes m-MTDATA mit einem Dotierverhältnis 50:1 beträgt die Leitfähigkeit demgegenüber etwa 1e-5 S/cm. Es liegt ein vollständiger Ladungsübertrag von Matrix zu Dotand vor.

Ausführungsbeispiel 4

In einem weiteren Ausführungsbeispiel wird eine Mischung aus zwei Materialien prozessiert, die unterhalb ihrer Verdampfungstemperatur zunächst in die flüssige Phase übergehen. Es ist auch möglich, daß nur ein Material der Mischung unterhalb der Verdampfungstemperatur in die flüssige Phase übergeht, mindestens ein anderes aber in der festen Phase verbleibt. Man würde dann zum Beispiel aus einer Lösung, einer Emulsion oder Dispersion aufdampfen. Bei geschickter Wahl der Matrix- und Dopingmaterialien kann man auch in diesem Fall, ein konstantes Verhältnis der Aufdampfraten und entsprechend die gewünschte dotierte Schicht erzielen. In einer besonders vorteilhaften Ausgestaltung der Erfindung liegen die Materialien in der Schmelze in einem azeotropen Gemisch vor.

Bei einer Ausführung dieses Ausführungsbeispiels wurden 95 mg TPD und 13.5 mg $F_4$-TCNQ eingewogen und in einem Keramikmörser miteinander verrieben. Das resultierende Pulver wurde in einen Verdampfertiegel gefüllt und zunächst auf 150°C geheizt. Dabei wurde beobachtet, daß sich bereits eine dotierte Schicht auf dem Substrat abscheidet. Nach etwa 3 Minuten bei 150°C wurde der Verdampfer abgekühlt. Eine Inspektion des Verdampfertiegels ergab, daß die TPD:$F_4$-TCNQ Mischung geschmolzen ist.

In einem zweiten Schritt wurde der Verdampfer auf 150°C geheizt. Die Leitfähigkeit der auf dem Substrat entstehenden Schicht wurde gemessen. Nach einer Anlaufphase von 7 Minuten entsteht eine dotierte Schicht mit einer erhöhten Leitfähigkeit von über 1e-8 S/cm bis das Material verbraucht ist.

Die in der vorstehenden Beschreibung und den Ansprüchen offenbarten Merkmale der Erfindung können sowohl einzeln als auch in beliebiger Kombination für die Verwirklichung der Erfindung in ihren verschiedenen Ausführungsformen von Bedeutung sein.

**Patentansprüche**

1. Verfahren zum Herstellen einer Schicht aus einem dotierten Halbleitermaterial auf einem Substrat mittels Abscheiden, wobei das dotierte Halbleitermaterial mindestens ein Halbleiter-Matrixmaterial und mindestens ein Dotierungsmaterial enthält, **dadurch gekennzeichnet, daß** eine Mischung des mindestens einen Halbleiter-Matrixmaterials und des mindestens einen Dotierungsmaterials mit Hilfe einer Verdampfungsquelle in eine Dampfphase überführt und anschließend auf dem Substrat abgeschieden wird.

2. Verfahren nach Anspruch 1, **dadurch gekennzeichnet, daß** für das mindestens eine Halbleiter-Matrixmaterial ein weniger flüchtiges Halbleiter-Matrixmaterial verwendet wird, so daß die Flüchtigkeit des mindestens einen Dotierungsmaterials größer als die Flüchtigkeit des mindestens einen Halbleiter-Matrixmaterials ist.

3. Verfahren nach Anspruch 1, **dadurch gekennzeichnet, daß** für das mindestens eine Halbleiter-Matrixmaterial ein flüchtigeres Halbleiter-Matrixmaterial verwendet wird, so daß die Flüchtigkeit des mindestens einen Dotierungsmaterials kleiner als die Flüchtigkeit des mindestens einen Halbleiter-Matrixmaterials ist.

4. Verfahren nach Anspruch 2 oder 3, **dadurch gekennzeichnet, daß** die Verdampfungs- / Sublimationstemperatur des mindestens einen Halbleiter-Matrixmaterials und die Verdampfungs- / Sublimationstemperatur des mindestens einen Dotierungsmaterials sich um weniger als etwa 50 °C, vorzugsweise um weniger als etwa 20 °C unterscheiden.

5. Verfahren nach einem der vorangehenden Ansprüche, **dadurch gekennzeichnet, daß** ein molarer Anteil des Materials mit der größeren Flüchtigkeit in der Mischung des mindestens einen Halbleiter-Matrixmaterials und des mindestens einen Dotierungsmaterials kleiner als etwa 50%, vorzugsweise kleiner als etwa 20% ist.

6. Verfahren nach einem der vorangehenden Ansprüche, **dadurch gekennzeichnet, daß** das Matrixmaterial und/ oder das Dotierungsmaterial aus der flüssigen Phase verdampft werden.

7. Verfahren nach einem der Ansprüche 1 bis 5 **dadurch gekennzeichnet, daß** die Mischung aus der festen Phase sublimiert wird.

8. Verfahren nach Anspruch 7, **dadurch gekennzeichnet, daß** die feste Mischung in Form eines verpreßten Materials in die Verdampfungsquelle eingebracht wird.

9. Verfahren nach einem der vorangehenden Ansprüche, **dadurch gekennzeichnet, daß** das mindestens eine Halbleiter-Matrixmaterial und / oder das mindestens eine Dotierungsmaterial vor dem Einbringen in die Verdampfungsquelle zermahlen werden.

10. Verfahren nach einem der vorangehenden Ansprüche, **dadurch gekennzeichnet, daß** das mindestens eine Halbleiter-Matrixmaterial und das mindestens eine Dotierungsmaterial in der Verdampfungsquelle chemisch miteinander reagieren, wodurch die Flüchtigkeit des mindestens einen Halbleiter-Matrixmaterials und / oder des mindestens einen Dotierungsmaterials verändert wird.

11. Verfahren nach Anspruch 10, **dadurch gekennzeichnet, daß** die Flüchtigkeit des mindestens einen Halbleiter-Matrixmaterials und die Flüchtigkeit des mindestens einen Dotierungsmaterials einander angenähert werden.

12. Verfahren nach einem der vorangehenden Ansprüche, **dadurch gekennzeichnet, daß** ein Verhältnis einer Rate, mit der das mindestens eine Halbleiter-Matrixmaterial in der Verdampfungsquelle in die Dampfphase überführt wird, und einer Rate, mit der das mindestens eine Dotierungsmaterial in die Dampfphase überführt wird, im wesentlichen gleich gehalten wird.

13. Verfahren nach einem der vorangehenden Ansprüche, **dadurch gekennzeichnet, daß** die Mischung in der Verdampfungsquelle mittels Zuführen von thermischer Energie in die Dampfphase überführt wird.

14. Verfahren nach einem der Ansprüche 1 bis 12, **dadurch gekennzeichnet, daß** die Mischung in der Verdampfungsquelle mittels Einstrahlen von Laserlichtimpulsen in die Dampfphase überführt wird.

15. Verfahren nach einem der Ansprüche 1 bis 12, **dadurch gekennzeichnet, daß** die Mischung des mindestens einen Halbleiter-Matrixmaterials und des mindestens einen Dotierungsmaterials mittels Molekularstrahlepitaxie abgeschieden wird.

16. Vorrichtung zum Herstellen einer Schicht aus einem dotierten Halbleitermaterial auf einem Substrat mit dem Verfahren nach einem der vorangehenden Ansprüche, **gekenn - zeichnet durch** eine eine Mischung mindestens eines Halbleiter-Matrixmaterials und mindestens eines Dotierungsmaterials aufnehmende Verdampfungsquelle.


**Geänderte Patentansprüche gemäss Regel 86(2) EPÜ.**

**1.** Verfahren zum Herstellen einer Ladungsträgertransportschicht aus einem dotierten Ladungsträgertransport-Halbleitermaterial auf einem Substrat mittels Abscheiden, wobei das dotierte Ladungsträgertransport-Halbleitermaterial mindestens ein Halbleiter-Matrixmaterial und mindestens ein Dotierungsmaterial enthält, welches die elektrische Leitfähigkeit des Halbleiter-Matrixmaterials für Ladungsträger erhöht, **dadurch gekennzeichnet, daß** eine Mischung des mindestens einen Halbleiter-Matrixmaterials und des mindestens einen Dotierungsmaterials mit Hilfe einer Verdampfungsquelle in eine Dampfphase überführt und anschließend auf dem Substrat abgeschieden wird.

**2.** Verfahren nach Anspruch 1, **dadurch gekennzeichnet, daß** für das mindestens eine Halbleiter-Matrixmaterial ein weniger flüchtiges Halbleiter-Matrixmaterial verwendet wird, so daß die Flüchtigkeit des mindestens einen Dotierungsmaterials größer als die Flüchtigkeit des mindestens einen Halbleiter-Matrixmaterials ist.

**3.** Verfahren nach Anspruch 1, **dadurch gekennzeichnet, daß** für das mindestens eine Halbleiter-Matrixmaterial ein flüchtigeres Halbleiter-Matrixmaterial verwendet wird, so daß die Flüchtigkeit des mindestens einen Dotierungsmaterials kleiner als die Flüchtigkeit des mindestens einen Halbleiter-Matrixmaterials ist.

**4.** Verfahren nach Anspruch 2 oder 3, **dadurch gekennzeichnet, daß** die Verdampfungs- / Sublimationstemperatur des mindestens einen Halbleiter-Matrixmaterials und die Verdampfungs- / Sublimationstemperatur des mindestens einen Dotierungsmaterials sich um weniger als etwa 50 °C, vorzugsweise um weniger als etwa 20 °C unterscheiden.

**5.** Verfahren nach einem der vorangehenden Ansprüche, **dadurch gekennzeichnet, daß** ein molarer Anteil des Materials mit der größeren Flüchtigkeit in der Mischung des mindestens einen Halbleiter-Matrixmaterials und des mindestens einen Dotierungsmaterials kleiner als etwa 50%, vorzugsweise kleiner als etwa 20% ist.

**6.** Verfahren nach einem der vorangehenden Ansprüche, **dadurch gekennzeichnet, daß** das Matrixmaterial und/ oder das Dotierungsmaterial aus der flüssigen Phase verdampft werden.

**7.** Verfahren nach einem der Ansprüche 1 bis 5 **dadurch gekennzeichnet, daß** die Mischung aus der festen Phase sublimiert wird.

**8.** Verfahren nach Anspruch 7, **dadurch gekennzeichnet, daß** die feste Mischung in Form eines verpreßten Materials in die Verdampfungsquelle eingebracht wird.

**9.** Verfahren nach einem der vorangehenden Ansprüche, **dadurch gekennzeichnet, daß** das mindestens eine Halbleiter-Matrixmaterial und / oder das mindestens eine Dotierungsmaterial vor dem Einbringen in die Verdampfungsquelle zermahlen werden.

**10.** Verfahren nach einem der vorangehenden Ansprüche, **dadurch gekennzeichnet, daß** wenigstens ein Teil des mindestens einen Halbleiter-Matrixmaterials und des mindestens einen Dotierungsmaterials in der Verdampfungsquelle chemisch miteinander zu einem Reaktionsprodukt reagieren, wodurch die Flüchtigkeit des mindestens einen Halbleiter-Matrixmaterials und / oder des mindestens einen Dotierungsmaterials verändert wird, und daß das Reaktionsprodukt in der Verdampfungsquelle in das mindestens eine Halbleiter-Matrixmaterial und das mindestens eine Dotierungsmaterial überführt wird, so daß das mindestens eine Halbleiter-Matrixmaterial und das mindestens eine Dotierungsmaterial gasförmig werden, und anschließend das mindestens eine Halbleiter-Matrixmaterials und das mindestens eine Dotierungsmaterials auf dem Substrat abgeschieden werden.

**11.** Verfahren nach Anspruch 10, **dadurch gekennzeichnet, daß** die Flüchtigkeit des mindestens einen Halbleiter-Matrixmaterials und die Flüchtigkeit des mindestens einen Dotierungsmaterials einander angenähert werden.

**12.** Verfahren nach Anspruch 1 oder einem der Ansprüche 4 bis 11, **dadurch gekennzeichnet, daß** ein Verhältnis einer Rate, mit der das mindestens eine Halbleiter-Matrixmaterial in der Verdampfungsquelle in die Dampfphase überführt wird, und einer Rate, mit der das mindestens eine Dotierungsmaterial in die Dampfphase überführt wird, im wesentlichen gleich gehalten wird.

**13.** Verfahren nach einem der vorangehenden Ansprüche, **dadurch gekennzeichnet, daß** die Mischung in der Verdampfungsquelle mittels Zuführen von thermischer Energie in die Dampfphase überführt wird.

**14.** Verfahren nach einem der Ansprüche 1 bis 12, **dadurch gekennzeichnet, daß** die Mischung in der Verdampfungsquelle mittels Einstrahlen von Laserlichtimpulsen in die Dampfphase überführt wird.

**15.** Verfahren nach einem der Ansprüche 1 bis 12, **dadurch gekennzeichnet, daß** die Mischung des mindestens einen Halbleiter-Matrixmaterials und des mindestens einen Dotierungsmaterials mittels Molekularstrahlepitaxie abgeschieden wird.

**EUROPÄISCHER RECHERCHENBERICHT**

Nummer der Anmeldung

EP 04 02 3606

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | EP 1 156 536 A (EASTMAN KODAK COMPANY) 21. November 2001 (2001-11-21) * Absätze [0014], [0025], [0026] * ----- | 1-8, 11-13,16 | H01L51/40 C23C14/12 |
| X | EP 1 454 736 A (EASTMAN KODAK COMPANY) 8. September 2004 (2004-09-08) * Absatz [0017] * ----- | 1,16 | |
| X | US 2003/180457 A1 (MURAKAMI MASAKAZU ET AL) 25. September 2003 (2003-09-25) * Absatz [0183] * * Seite 16, Spalte 2, Zeile 53 - Zeile 55 * ----- | 1 | |
| X | EP 1 017 117 A (TDK CORPORATION) 5. Juli 2000 (2000-07-05) * Absatz [0039] * ----- | 1-3,12, 16 | |
| L | EP 1 132 493 A (KIDO, JUNJI; INTERNATIONAL MANUFACTURING AND ENGINEERING SERVICES CO.,) 12. September 2001 (2001-09-12) * Absatz [0030] * ----- | 2,3 | RECHERCHIERTE SACHGEBIETE (Int.Cl.7) C23C H01L H01B |

Der vorliegende Recherchenbericht wurde für alle Patentansprüche erstellt

| Recherchenort | Abschlußdatum der Recherche | Prüfer |
|---|---|---|
| München | 17. Februar 2005 | Pusch, C |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
 
& : Mitglied der gleichen Patentfamilie, übereinstimmendes
    Dokument

EPO FORM 1503 03.82 (P04C03)

**EP 1 643 568 A1**

**ANHANG ZUM EUROPÄISCHEN RECHERCHENBERICHT
ÜBER DIE EUROPÄISCHE PATENTANMELDUNG NR.**

EP 04 02 3606

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

17-02-2005

| Im Recherchenbericht angeführtes Patentdokument | | Datum der Veröffentlichung | Mitglied(er) der Patentfamilie | | | Datum der Veröffentlichung |
|---|---|---|---|---|---|---|
| EP 1156536 | A | 21-11-2001 | CN | 1336411 | A | 20-02-2002 |
| | | | EP | 1156536 | A2 | 21-11-2001 |
| | | | JP | 2002025770 | A | 25-01-2002 |
| | | | TW | 593622 | B | 21-06-2004 |
| | | | US | 2004016907 | A1 | 29-01-2004 |
| EP 1454736 | A | 08-09-2004 | US | 2004173929 | A1 | 09-09-2004 |
| | | | EP | 1454736 | A2 | 08-09-2004 |
| | | | JP | 2004273456 | A | 30-09-2004 |
| US 2003180457 | A1 | 25-09-2003 | CN | 1440222 | A | 03-09-2003 |
| | | | JP | 2003301259 | A | 24-10-2003 |
| EP 1017117 | A | 05-07-2000 | JP | 2000252074 | A | 14-09-2000 |
| | | | EP | 1017117 | A2 | 05-07-2000 |
| | | | US | 6166488 | A | 26-12-2000 |
| EP 1132493 | A | 12-09-2001 | CN | 1320718 | A | 07-11-2001 |
| | | | EP | 1132493 | A2 | 12-09-2001 |
| | | | JP | 2001323367 | A | 22-11-2001 |
| | | | US | 2001021415 | A1 | 13-09-2001 |

EPO FORM P0461

Für nähere Einzelheiten zu diesem Anhang : siehe Amtsblatt des Europäischen Patentamts, Nr.12/82